# FASCICULE DE BREVET EUROPEEN

(11) **EP 1 094 492 B1**
(45) Date de publication et mention de la délivrance du brevet: **26.12.2007**
(21) Numéro de dépôt: 00420212.3
(22) Date de dépôt: 19.10.2000
(51) Int. Cl.: H01J 37/28, G09B 5/02, H04N 5/225, H04N 9/00, H01J 37/22

(54) **Méthode de réalisation d'un film vidéo sur au moins un animal de faible taille**
Methode zur Erzeugung eines Videofilms von zumindest kleinen Tieren
Method for realizing a motion picture video of at least tiny animals

(30) Priorité: 21.10.1999 FR 9913383
(43) Date de publication de la demande: 25.04.2001
(73) Titulaire: Mona Lisa Production, 69001 Lyon (FR)
(72) Inventeur: Berrod, Thierry Noel Christian, 69650 Saint Germain au Mont D'Or (FR)
(74) Mandataire: Myon, Gérard Jean-Pierre

(56) Documents cités:
- WO-A-93/03491
- FR-A- 2 718 913
- US-A- 4 720 633
- US-A- 5 097 134
- US-A- 5 598 218

## Description

L'invention a trait à une méthode de réalisation d'un film vidéo sur au moins un animal de faible taille.

Des essais de réalisation de films documentaires sur les animaux de taille microscopique, ont été effectués avec un microscope à vide pratiquement total, tel que connu de US-A-5,212,383. Le travail en mode "vide pratiquement total" ou "haut vide" permet d'obtenir un signal vidéo de type "télévision" qui, bien que de qualité moyenne, peut être exploité. Cependant, un microscope travaillant à haut vide permet uniquement l'observation d'échantillons non fragiles qui n'éclatent pas et ne se dessèchent pas trop vite au vide considéré. Dans le domaine animal, des tiques ou des puces peuvent être observées car elles sont pourvues d'une cuticule ou carapace les protégeant partiellement des conditions d'exposition. Au contraire, d'autres animaux tels que les acariens et les poux se déforment et se dessèchent sous un vide trop poussé, de telle sorte qu'ils ne peuvent être observés qu'après avoir été revêtus d'une couche de métallisation, ce qui induit nécessairement l'observation d'animaux morts. Le vide pratiquement total induit également une mort rapide des animaux à cuticule.

Or, il est important sur le plan scientifique et documentaire de pouvoir observer le comportement d'animaux vivants.

Il existe des microscopes à vide partiel dits microscopes "environnementaux" qui permettent l'observation d'échantillons de faible taille, avec la possibilité de faire varier la pression de quelques torrs et ainsi de conserver un échantillon dans une chambre avec de l'air qui peut être maintenu à une température variable et à une pression relativement élevée, notamment en comparaison aux microscopes à haut vide. Un tel microscope est commercialisé par la société PHILIPS OPTIQUE ELECTRONIQUE sous la dénomination ESEM. Si un tel matériel est adapté à l'observation d'objets inanimés, il ne permet pas la réalisation de films vidéo car le signal émis en mode "télévision" est brouillé par les interférences entre le faisceau d'électrons et les molécules de gaz présentes dans l'enceinte. En mode de scannérisation, plus le balayage est lent, plus l'image est nette. Les vitesses de balayage utilisées en mode de scannérisation sont donc relativement faibles, de sorte qu'une ligne de balayage apparaît en permanence sur les images fournies par ce genre de microscope en mode de scannérisation. En outre, du fait du vide relatif créé, les animaux non protégés par une cuticule bougent lentement, ce qui n'est pas représentatif de leur comportement dans des conditions atmosphériques normales. C'est pourquoi, aucun procédé de prise de vues satisfaisant n'a jusqu'à présent pu être mis au point, en particulier dans une optique de vulgarisation pour laquelle la qualité des images obtenues est essentielle.

US-A-4,720,633 divulgue un microscope qui utilise une colonne à vide total et une colonne à vide partiel associées à une chambre, dans laquelle est disposée un spécimen, et à des moyens d'affichage et d'enregistrement. Ce matériel permet de réaliser des photographies mais par des séquences animées utilisables dans un film.

C'est à ces problèmes qu'entend plus particulièrement remédier l'invention en proposant un nouveau procédé de prise de vues et de modification d'un signal vidéo qui permet, notamment, l'observation d'animaux microscopiques vivants, avec des images de qualité suffisante pour permettre leur diffusion auprès d'un large public.

Dans cet esprit, l'invention concerne une méthode selon la revendication 1.

Grâce à l'étape d'accélération du signal, la qualité du signal vidéo peut être sensiblement améliorée du fait de la suppression de la ligne de balayage présente sur chaque image. Le procédé de l'invention permet également de rendre plus attractives les images obtenues dans la mesure où le mouvement des animaux observés, qui est généralement artificiellement lent du fait des conditions de vide partiel dans lequel ils évoluent, à l'air plus "réaliste" du fait de cette accélération.

La méthode de l'invention permet d'acquérir et de divulguer largement les connaissances scientifiques au sujet de tels animaux, généralement mal connus.

Selon des aspects avantageux mais non obligatoires de l'invention, le procédé incorpore une ou plusieurs des caractéristiques des revendications 2 à 10. En particulier,
- Le coefficient d'accélération du signal est supérieur à 5, notamment compris entre 5 et 200.
- Le coefficient d'accélération du signal est fonction de la nature de l'échantillon. En effet, une accélération plus ou moins importante peut être souhaitable en fonction de la réaction de l'échantillon observé au milieu dans lequel il évolue.

Selon un mode de réalisation de l'invention, l'accélération est obtenue par sélection de trames d'image parmi une série de trames, chaque image du signal accéléré étant composée d'une trame impaire et d'une trame paire sélectionnées. Selon une variante de réalisation de l'invention, l'accélération est obtenue par sélection, notamment à intervalles réguliers, d'images parmi une série d'images successives.

Selon un autre aspect avantageux de l'invention, le procédé comprend des étapes supplémentaires de débruitage et de colorisation du signal accéléré. Ces étapes permettent d'améliorer la qualité visuelle et l'effet de relief de la séquence filmée.

Selon un aspect avantageux de l'invention, la méthode consiste à maintenir l'animal à une température relativement faible, comprise entre 3 et à 10°C, au cours des prises de vues. Cette température relativement basse permet d'augmenter la durée de vie des animaux observés dans le milieu considéré.

Selon un autre aspect avantageux de l'invention, la méthode consiste à réaliser un vide compris entre 400 et 900 pascals dans l'enceinte du microscope. Cette valeur de vide relatif permet une survie de plusieurs minutes des animaux observés, en particulier du fait de l'humidité relative qui est conservée.

L'invention sera mieux comprise et d'autres avantages de celle-ci apparaîtront plus clairement à la lumière de la description qui va suivre de deux modes de réalisation d'un procédé de prise de vues appliqué à une méthode de réalisation d'un film vidéo animalier conforme à son principe, donnée uniquement à titre d'exemple et faite en référence aux dessins annexés dans lesquels :
- La figure 1 est une représentation schématique de principe d'une installation permettant de mettre en oeuvre un premier procédé conforme à l'invention ;
- La figure 2 est une représentation schématique des images obtenues avec l'installation de la figure 1 ;
- La figure 3 est un schéma bloc du procédé de l'invention et
- La figure 4 est une représentation analogue à la figure 2 pour un second procédé conforme à l'invention.

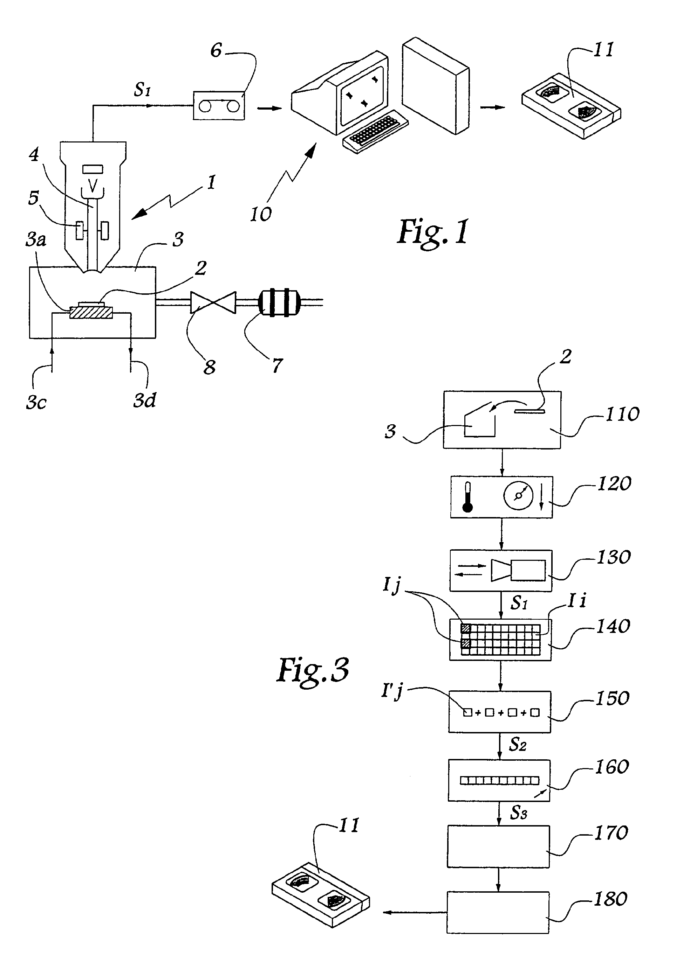

L'installation représentée à la figure 1 comprend un microscope à balayage électronique 1 de type environnemental, c'est-à-dire permettant l'observation d'un échantillon 2 situé dans une chambre ou enceinte 3 dans laquelle règne un vide partiel. Le microscope 1 comprend un canon à électrons 4 et des lentilles électromagnétiques 5. Il est associé à une unité 6 d'enregistrement des images transmises par les lentilles 5 sur un support magnétique tel qu'une bande vidéo.

L'enceinte 3 est reliée à une pompe 7 par un jeu de vannes 8, les éléments 7 et 8 visibles à la figure 1 représentant plusieurs systèmes associés à la enceinte 3.

Le microscope 1 peut être du type commercialisé par la société PHILIPS OPTIQUE ELECTRONIQUE sous la référence ESEM et permet l'observation d'un échantillon 2 grâce à un bombardement électronique de cet échantillon, un détecteur étant prévu en un emplacement approprié pour coopérer avec le canon à électrons 4.

La tension d'accélération du microscope est choisie relativement élevée, de l'ordre de 15 kV pour une prise de vues sur des acariens, afin d'obtenir une image de qualité. La taille du spot est réglée pour que l'image soit nette et le moins possible bruitée. A fort grossissement, la taille du spot est diminuée afin de visualiser, autant que faire se peut, les détails et d'améliorer la netteté de l'image.

Le contraste et la brillance sont ajustés pour régler les niveaux de gris et la brillance de l'image. La distance de travail, c'est-à-dire la distance entre l'échantillon et le détecteur est choisie de l'ordre de 10 mm, ce qui permet,en particulier, de faire tourner ou de pencher l'échantillon pour visualiser un animal de face, sans déréglage de la focalisation de l'appareil ou sortie de l'animal de la fenêtre de prise de vues. Les mouvements précités permettent de simuler un mouvement de "travelling" du détecteur.

Dans le cas d'une méthode de réalisation d'un film vidéo sur des acariens, on suppose qu'un acarien 101 a été localisé grâce au microscope 1 et que les images obtenues dans l'unité 6 sont centrées sur cet acarien.

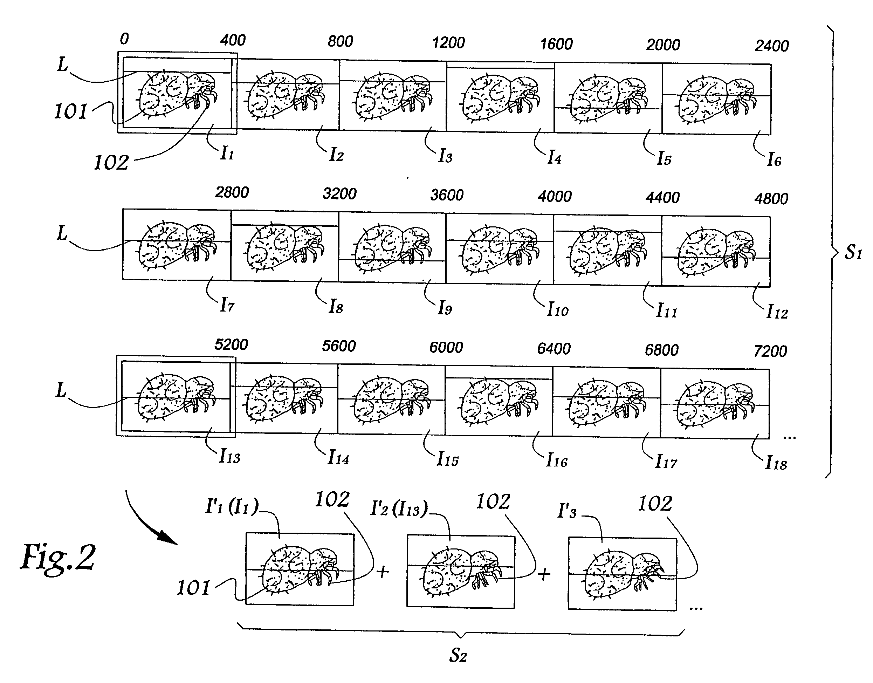

Le microscope est utilisé en mode avec balayage. Le signal S₁ transmis par le microscope 1 à l'unité 6 est donc un signal formé d'une succession d'images I₁, I₂, I₃ ... obtenues par scannérisation. Des images I₁ à I₁₈ sont représentées sur la figure 2. Le nombre N d'images de la séquence est important et l'on note I₁ une image parmi les images I₁ à I_{N}.

La température de l'échantillon 2 dans l'enceinte 3 est maintenue à une valeur comprise entre 4 et 5°C avec une humidité maximum de l'ordre de 60%. La température relativement faible qui a été choisie permet également d'augmenter la durée de vie des animaux observés.

Il est vrai qu'une température relativement élevée permettrait de simuler leur réaction. Cependant, une température relativement basse, en règle générale comprise entre 3 et 10°C, est préférée pour permettre une prise de vues sur un intervalle de temps suffisant, car une température élevée conduit à une mort rapide des animaux de l'échantillon.

Le contrôle de la température de l'échantillon 2 est obtenu par une plaque de refroidissement 3a disposée dans l'enceinte 3, au contact de l'échantillon, cette plaque formant une cavité intérieure alimentée en fluide caloporteur à une température prédéterminée grâce à des canaux 3c et 3d.

L'humidité est un facteur essentiel de survie des échantillons. En effet, la déshydratation est le principal facteur de mortalité des échantillons. Une humidité d'environ 60% peut être obtenue dans l'enceinte en respectant des conditions de pression et de température correspondant à l'équilibre de l'eau entre les phases aqueuse et gazeuse, à la pression de vapeur saturante. Pour des valeurs de pression comprises entre 1 et 10 torrs, une température de l'ordre de 5°C est satisfaisante. Si cette température est augmentée de façon trop importante, notamment au-delà de 10°C, l'eau s'épavore et l'échantillon de déshydrate. Si on diminue la température dans l'enceinte, l'eau a tendance à se liquéfier ce qui correspond à une diminution de l'humidité relative dans l'enceinte sans désèchement excessif. Pour cette raison et en tenant compte du fait que le froid ralentit mais ne tue pas les échantillons, on choisit de travailler plutôt à basse température.

En règle générale, pour l'observation d'acariens ou de poux, la valeur de la pression dans l'enceinte 3 est conservée dans une plage comprise entre 3 et 6,5 torrs (environ 400 à environ 865 pascals) ce qui donne des images relativement nettes avec une durée de vie suffisante des animaux. Pour l'observation d'un acarien de type acarus siro (acariens du fromage), la pression dans la enceinte 3 est réglée à environ 4,7 torrs (627 pascals) afin de prolonger la durée de vie de l'animal.

Différents facteurs influent sur la durée de vie des animaux de l'échantillon. Tout d'abord, la tension d'accélération du microscope doit être la plus faible possible pour que le bombardement électronique des animaux soit faible. Pour la même raison, il est préférable de travailler avec une taille de spot relativement faible, ce qui correspond à un bombardement localisé de l'échantillon, et de limiter les plans de détail car, à fort grossissement, on administre à la zone observée un grand nombre d'électrons. Cependant, une phase à fort grossissement ultra-rapide, peut être utilisée afin de stimuler une sur-exitation de l'échantillon. Un animal qui se sent agressé peut déclencher un comportement de protection, ce qui est notamment le cas de l'acarien oribate qui rentre ou sort de sa coquille après une telle stimulation. La pression doit être la plus élevée possible car le vide gêne le plus souvent le mouvement des échantillons.

Le microscope 1 est utilisé en mode "scan" avec une vitesse de balayage de 0,84 milliseconde par ligne, le nombre de lignes étant de 488 lignes par images. Ainsi, la durée de prise de vues totale d'une image est d'environ 400 millisecondes, ce qui correspond à environ 2,5 images par seconde.

A la figure 2, les valeurs de 400, 800, ... indiquées correspondent à la durée en millisecondes écoulée depuis le début d'une prise de vues à un instant 0.

Chaque image Iᵢ est traversée par une ligne de balayage L qui, compte tenu de la durée de prise de vues de chaque image, est visible lorsqu'on visionne une succession d'images I₁ correspondant à une séquence, à une vitesse de 2,5 images par seconde.

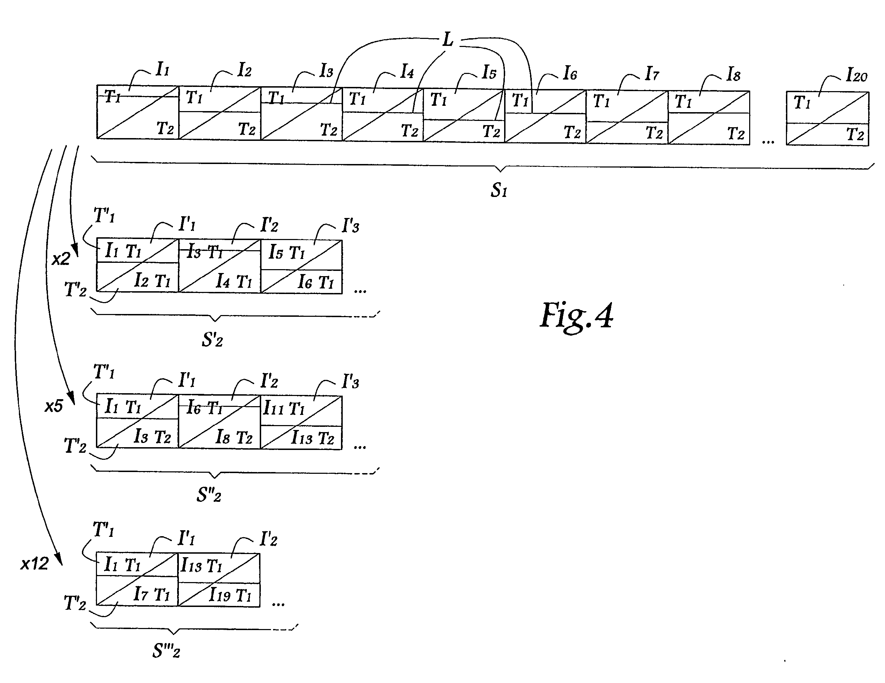

Comme il ressort plus particulièrement de la figure 3, le procédé de l'invention consiste, dans une première étape 110 à introduire l'échantillon 2 dans l'enceinte 3, puis dans une seconde étape 120 à abaisser la pression dans l'enceinte 3 à une valeur adéquate tout en contrôlant la température de l'échantillon 2 dans cette enceinte. Il est ensuite procédé, dans l'étape 130, à l'acquisition des images Iᵢ grâce au microscope 1.

Les images acquises dans l'unité 6 sont alors transmises à une station de post-traitement 10 dans laquelle il est procédé à une accélération du signal S₁ en sélectionnant une image Iᵢ toutes les 12 images, les images I'ᵢ sélectionnées étant représentées avec un double cadre à la figure 2. Dans l'exemple représenté, l'image I₁ est sélectionnée comme image I'₁ alors que l'image I₁₃ est sélectionnée comme image I'₂.

On note I'ⱼ les images sélectionnées. Les images I'ⱼ sont sélectionnées à l'étape 140 du procédé avec un écart de 4,8 secondes environ correspondant à 12 fois 400 millisecondes. Ces images I'ⱼ sont ensuite juxtaposées pour former un signal accéléré S₂ comme représenté à l'étape 150 à la figure 3.

L'accélération du signal S₁ en signal S₂ permet également de détecter plus facilement un mouvement de l'acarien 101. On suppose que l'acarien 101 bouge une patte 102 visible sur la droite des figures I₁. Compte tenu de l'environnement hostile dans lequel évolue l'acarien 101, le mouvement de sa patte 102 se produit à très faible vitesse, ce qui rend peu attrayante l'observation d'un tel phénomène à vitesse normale. L'accélération du signal S₁ en signal S₂ permet de visualiser un mouvement de la patte 102 à une vitesse beaucoup plus importante qui peut être considérée comme plus représentative du comportement de l'acarien 101 dans une atmosphère normale et, à ce titre, plus "réaliste". Le mouvement de la patte 102 est visible au niveau du signal S₂ à la figure 2.

L'accélération du signal S₁ en signal S₂ permet également de supprimer la perception qu'a l'utilisateur des lignes de balayage L car les images I'ⱼ sont juxtaposées dans le signal S₂, de telle sorte qu'elles se succèdent à une fréquence d'environ 25 hertz, la ligne de balayage apparaissant sur chaque image I'₁ pour une durée d'environ 40 millisecondes inférieure à la durée minimale de perception rétinienne.

Selon une caractéristique optionnelle du procédé de l'invention, le signal S₂ obtenu lors de l'étape 150 peut être encore accéléré, dans une étape ultérieure 160, en un signal S₃, cette seconde accélération étant effectuée pour rendre plus attractive la séquence S₂ reconstituée, notamment afin que le déplacement d'une patte 102 ne s'effectue pas sur une durée trop longue.

Lorsqu'une vitesse de défilement satisfaisante des images I'₁ a été obtenue, il est procédé à une étape de débruitage 170 dans laquelle les images sont "lissées" selon une technique connue afin de les rendre plus nettes en supprimant le bruit du signal. Une étape ultérieure de colorisation 180 permet d'accentuer les effets de relief sur les images du signal S₂ ou S₃, le signal obtenu pouvant alors être transféré sur un support magnétique, tel qu'une cassette vidéo 11, afin d'être commercialisé, comme matériel éducatif ou de vulgarisation scientifique, ou proposé à une chaîne de télévision pour intégration dans l'un de ses programmes.

Le coefficient d'accélération utilisé entre les signaux S₁ et S₂ ou S₁ et S₃ est variable et dépend en particulier de la nature des animaux observés, une accélération plus ou moins importante pouvant être choisie afin de rendre plus "vivante" une séquence observée. En pratique, un coefficient d'accélération supérieur à 5 permet de supprimer la perception des lignes de balayage, ce coefficient pouvant être porté jusqu'à 200, voire plus, pour accélérer la séquence afin de compenser les effets du vide relatif sur l'animal observé.

Bien entendu, certains animaux réagissent plus rapidement dans certains milieux et le coefficient d'accélération entre les signaux S₂ et S₃ peut être adapté en fonction de chaque animal observé.

Dans le second mode de réalisation du procédé de l'invention représenté à la figure 4, on tire parti de ce que chaque image I₁ est composée d'une trame impaire T₁ et d'une trame paire T₂. On considère une séquence formée de vingt images I₁ à I₂₀, soit 40 trames I₁T₁, I₁T₂, I₂T₁ ... I₂₀T₂ comportant chacune une ligne de balayage L.

Dans le cas où l'on souhaite doubler la vitesse du signal S₁, la construction des images I'ⱼ du signal accéléré S₂ peut être effectuée en ne retenant que les trames impaires T₁ des images Iᵢ, ce qui est représenté par le signal S'₂ à la figure 4. Chaque image I'ⱼ du signal S'₂ est formé de deux trames sélectionnées comme indiqué ci-dessus formant alternativement les trames impaires T'₁ et paires T'₂ des images I'ⱼ. La trame impaire T'₁ de la première image I'₁ du signal S₂ est la trame impaire de l'image I₁ alors que la trame paire de l'image I'₁ est la trame impaire de l'image I₂ et ainsi de suite. Ce signal S'₂ peut ensuite être accéléré dans une étape 160 analogue à celle envisagée en référence au premier mode de réalisation.

Lorsqu'une accélération avec un coefficient 5 est envisagée, et en considérant que la première trame sélectionnée pour l'image I'₁ est la trame I₁T₁, alors la trame paire de l'image I'₁ est la trame I₃T₂. La trame impaire de l'image I'₂ est I₆T₁ alors que la trame paire de l'image I'₂ est I₈T₂ etc... On obtient ainsi un signal accéléré S''₂ dont les images I'ⱼ sont formées des trames paires et impaires sélectionnées, ce signal S''₂ pouvant éventuellement être soumis à une accélération supplémentaire comme indiquée précédemment à l'étape 160.

Lorsqu'une accélération avec un coefficient 12 est recherchée et en considérant que la première trame ou trame impaire sélectionnée pour l'image I'₁ est la trame I₁T₁, la seconde trame ou trame paire sélectionnée pour I'₁ est la trame I₇T₁. En répétant régulièrement cette opération on forme un signal S'''₂ pouvant éventuellement être accéléré comme indiqué en 160 ci-dessus.

La visualisation des signaux S'₂, S''₂ ou S'''₂ a une vitesse de 25 images par secondes permet de rendre imperceptibles à l'oeil les lignes de balayage L.

Les signaux S'₂, S''₂ et S'''₂ peuvent également être soumis aux étapes de débruitage 170 et de colorisation 180 précédemment évoquées.

Quel que soit le mode de réalisation envisagé, les étapes 140 à 160 de constitution et des signaux accélérés S₂, S'₂, S''₂, S'''₂ peuvent être réalisés avec un banc de montage vidéo qui est un produit bien connu des professionnels du domaine considéré.

La vitesse de balayage utilisée est comprise entre 0,42 milliseconde par ligne et 6,72 milliseconde par ligne, les valeurs de 0,84 et 1,68 milliseconde par ligne étant préférées car elles permettent d'obtenir une image de qualité et peu saccadée par la post-production correspondant à l'accélération du signal.

### Exemples de mise en oeuvre

Une colonie d'acarus siro a été observée pendant 180 secondes et la séquence obtenue a été accélérée avec un coefficient d'accélération de 12, ce qui donne une séquence de 15 secondes utilisables.

Dans le cas de poux, et compte tenu de la lenteur des déplacements des animaux observés, une seconde accélération est nécessaire, cette fois avec un coefficient compris entre 2 et 12, de telle sorte qu'une séquence originale de 180 secondes est transformée en une séquence utilisable de durée comprise entre 1,25 et 7,5 secondes.

Dans le cas de l'observation d'une colonie d'acariens varroas la plate forme de refroidissement 3a permet de limiter la vitesse de mouvement des animaux observés, alors qu'elle est utilisée, pour les autres espèces, principalement afin de limiter la déshydratation de l'échantillon. En effet, les acariens varroas sont relativement véloces et le mouvement filmé par un signal S₁ correspondant doit être relativement lent afin d'être à vitesse "normale" une fois accéléré.

## Revendications

1. Méthode de réalisation d'un film vidéo sur au moins un animal de faible taille, notamment de taille microscopique, dans laquelle on effectue des prises de vues et on modifie un signal vidéo, les prises de vues étant effectuées au moyen d'un microscope électronique à balayage (1) de type environnemental, ladite méthode comprenant une étape consistant à introduire (110) au moins un échantillon (2) contenant l'animal à observer dans une enceinte (3) dudit microscope et une étape consistant à enregistrer (130) un signal (S₁) obtenu par balayage électronique, ledit signal étant représentatif d'une succession d'images (Iᵢ) formant une séquence, ladite méthode comprenant des étapes consistant à :
- ajuster (120) la pression de gaz régnant dans ladite enceinte en fonction du type de l'animal et
- traiter, au cours d'une étape de post-traitement (140-160), les images (Iᵢ) dudit signal (S₁) et créer un signal accéléré (S₂, S'₂, S''₂, S'''₂, S₃) dans lequel une ligne de balayage (L) présente sur lesdites images (Iᵢ, I'ⱼ) n'est pas perceptible à l'oeil (S₂, S'₂, S''₂, S'''₂, S₃).

2. Méthode selon la revendication 1, **caractérisée en ce que** le coefficient d'accélération dudit signal (S₁, S₂, S'₂, S''₂, S'''₂, S₃) est supérieur à 5.

3. Méthode selon la revendication 2, **caractérisée en ce que** ledit coefficient d'accélération est compris entre 5 et 200.

4. Méthode selon l'une des revendications précédentes, **caractérisé en ce que** le coefficient d'accélération dudit signal (S₁, S₂, S'₂, S''₂, S'''₂, S₃) est fonction de la nature dudit échantillon (2), notamment de l'animal observé.

5. Méthode selon l'une des revendications précédentes, **caractérisé en ce que** ledit signal accéléré est obtenu par sélection de trames d'image (T'₁, T'₂) parmi une série de trames successives (IᵢT₁, IᵢT₂) dudit signal enregistré (S₁), chaque image du signal accéléré (S'₂, S''₂, S'''₂) étant composée d'une trame impaire (I₁T₁, I₃T₁, I₅T₁ ; I₁T₁, I₆T₁, I₁₁T₁; I₁T₁, I₁₃T₁ ...) et d'une trame paire (I₂T₁, I₄T₁, I₆T₁ ... ; I₃T₂, I₈T₂, I₁₃T₂ ... ;I₇T₁, I₁₉T₁ ...) sélectionnées.

6. Méthode selon l'une des revendications précédentes, **caractérisée en ce que** ledit signal accéléré est obtenu par sélection, notamment à intervalles réguliers, d'images (I'ⱼ) parmi une série d'images successives (Iᵢ) dudit signal enregistré (S₁).

7. Méthode selon l'une des revendications précédentes, **caractérisée en ce qu'**elle comprend une étape (170) de débruitage et une étape (180) de colorisation du signal accéléré (S₂, S'₂, S''₂, S'''₂, S₃).

8. Méthode selon la revendication 1, **caractérisée en ce qu'**elle consiste à maintenir ledit animal (101) à une température comprise entre 3 et 10°C au cours des prises de vues.

9. Méthode selon la revendication 1, **caractérisée en ce que** l'humidité maximale dans ladite enceinte (3) est de l'ordre de 60%.

10. Méthode selon l'une des revendications précédentes, **caractérisée en ce qu'**elle consiste à réaliser un vide compris entre 400 et 900 pascals dans ladite enceinte (3) au cours des prises de vues.

## Claims

1. Method for producing a video film on at least one small-sized animal, particularly of microscopic size, in which shots are taken and a video signal is modified, the shots being taken by means of a scanning electron microscope (1) of the environmental type, the said method comprising a step consisting of inserting (110) at least one sample (2) containing the animal to be observed in an enclosure (3) of the said microscope and a step consisting in recording (130) a signal (S₁) obtained by electronic scanning, the said signal being representative of a succession of images (Iᵢ) forming a sequence, the said method comprising steps consisting in:
- adjusting (120) the gas pressure existing in the said enclosure according to the type of animal and
- processing, during a post-processing step (140-160), the images (Iᵢ) of the said signal (S₁) and creating an accelerated signal (S₂, S'₂, S''₂, S'''₂, S₃) in which a scanning line (L) present on the said images (Iᵢ, I'ⱼ) is imperceptible to the eye (S₂, S'₂, S''₂, S'''₂, S₃).

2. Method according to Claim 1, **characterized in that** the acceleration coefficient of the said signal (S₁, S₂, S'₂, S''₂, S'''₂, S₃) is greater than 5.

3. Method according to Claim 2, **characterized in that** the said acceleration coefficient lies between 5 and 200.

4. Method according to one of the preceding claims, **characterized in that** the acceleration coefficient of the said signal (S₁, S₂, S'₂, S''₂, S'''₂, S₃) is a function of the nature of the said sample (2), particularly of the observed animal.

5. Method according to one of the preceding claims, **characterized in that** the said accelerated signal is obtained by selecting image frames (T'₁, T'₂) from a series of successive frames (IᵢT₁, IᵢT₂) of the said recorded signal (S₁), each image of the accelerated signal (S'₂, S''₂, S'''₂) being composed of an odd frame (I₁T₁, I₃T₁, I₅T₁; I₁T₁, I₅T₁, I₁₁T₁; I₁T₁, I₁₃T₁ etc.) and of an even frame (I₂T₁, I₄T₁, I₆T₁ etc.; I₃T₂, I₈T₂, I₁₃T₂, etc.; I₇T₁, I₁₉T₁, etc.) that are selected.

6. Method according to one of the preceding claims, **characterized in that** the said accelerated signal is obtained by selecting, particularly at regular intervals, images (I'ⱼ) from a series of successive images (Iᵢ) of the said recorded signal (S₁).

7. Method according to one of the preceding claims, **characterized in that** it comprises a step (170) of soundproofing and a step (180) of colouring the accelerated signal (S₂, S'₂, S''₂, S'''₂, S₃).

8. Method according to Claim 1, **characterized in that** it consists in keeping the said animal (101) at a temperature lying between 3 and 10°C during the shots.

9. Method according to Claim 1, **characterized in that** the maximum humidity in the said enclosure (3) is of the order of 60%.

10. Method according to one of the preceding claims, **characterized in that** it consists in producing a vacuum lying between 400 and 900 pascals in the said enclosure (3) during the shots.

## Patentansprüche

1. Verfahren zum Erzeugen eines Videofilms über zumindest ein Tier kleiner Größe, insbesondere mikroskopischer Größe, wobei Bildaufnahmen durchgeführt werden und ein Videosignal modifiziert wird, wobei die Bildaufnahmen mittels eines Rasterelektronenmikroskops (1) vom ESEM-Typ (Environmental Scanning Electron Microscope) durchgeführt werden, wobei das Verfahren einen Schritt, der aus dem Einführen (110) mindestens einer Probe (2), die das zu beobachtende Tier enthält, in eine Umschließung (3) des Mikroskops besteht, und einen Schritt, der aus dem Aufzeichnen (130) eines Signals (S₁) besteht, das durch elektronische Rasterung erhalten wird, enthält, wobei das Signal eine Abfolge von Bildern (Iᵢ) darstellt, die eine Sequenz bilden, wobei das Verfahren Schritte enthält, die bestehen aus:
- Einstellen (120) des Drucks des Gases, der in der Umschließung herrscht, in Abhängigkeit von der Art des Tiers, und
- während eines Nachbehandlungsschritts (140-160) Behandeln der Bilder (Iᵢ) des Signals (S₁) und Erzeugen eines beschleunigten Signals (S₂, S'₂, S''₂, S'''₂, S₃), bei dem eine Rasterlinie (L), die auf den Bildern (Iᵢ, I'ⱼ) vorhanden ist, vom Auge nicht wahrnehmbar ist (S₂, S'₂, S''₂, S'''₂, S₃).

2. Verfahren nach Anspruch 1, **dadurch gekennzeichnet, dass** der Beschleunigungskoeffizient des Signals (S₁, S₂, S'₂, S''₂, S'''₂, S₃) größer als 5 ist.

3. Verfahren nach Anspruch 2, **dadurch gekennzeichnet, dass** der Beschleunigungskoeffizient zwischen 5 und 200 liegt.

4. Verfahren nach einem der vorhergehenden Ansprüche, **dadurch gekennzeichnet, dass** der Beschleunigungskoeffizient des Signals (S₁, S₂, S'₂, S''₂, S'''₂, S₃) eine Funktion der Natur der Probe (2) ist, insbesondere des beobachteten Tiers.

5. Verfahren nach einem der vorhergehenden Ansprüche, **dadurch gekennzeichnet, dass** das beschleunigte Signal durch Auswahl von Rastern eines Bilds (T'₁, T'₂) aus einer Serie von aufeinanderfolgenden Rastern (IᵢT₁, IᵢT₂) des aufgezeichneten Signals (S₁) erhalten wird, wobei jedes Bild des beschleunigten Signals (S'₂, S''₂, S'''₂) aus einem ausgewählten ungeraden Raster (I₁T₁, I₃T₁, I₅T₁; I₁T₁, I₆T₁,I₁₁T₁; I₁T₁, I₁₃T₁ ...) und einem ausgewählten geraden Raster (I₂T₁, I₄T₁, I₆T₁ ...; I₃T₂, I₈T₂, I₁₃T₂ ...; I₇T₁, I₁₉T₁ ...) zusammengesetzt ist.

6. Verfahren nach einem der vorhergehenden Ansprüche, **dadurch gekennzeichnet, dass** das beschleunigte Signal durch Auswahl, insbesondere unter regelmäßigen Intervallen, von Bildern (I'ⱼ) aus einer Serie von aufeinanderfolgenden Bildern (Iᵢ) des aufgezeichneten Signals (S₁) erhalten wird.

7. Verfahrne nach einem der vorhergehenden Ansprüche, **dadurch gekennzeichnet, dass** das Verfahren eines Schritt (170) des Entrauschens und einen Schritt (180) des Färbens des beschleunigten Signals (S₂, S'₂, S''₂, S'''₂, S₃) enthält.

8. Verfahren nach Anspruch 1, **dadurch gekennzeichnet, dass** es darauf beruht, das Tier (101) auf einer Temperatur, die zwischen 3 und 10°C liegt, während der Bildaufnahmen zu halten.

9. Verfahren nach Anspruch 1, **dadurch gekennzeichnet, dass** die maximale Feuchtigkeit in der Umschließung (3) in der Größenordnung von 60% ist.

10. Verfahren nach einem der vorhergehenden Ansprüche, **dadurch gekennzeichnet, dass** es darauf beruht, ein Vakuum zwischen 400 und 900 Pascal in der Umschließung (3) während der Bildaufnahmen zu realisieren.
